# EUROPÄISCHE PATENTSCHRIFT

(11) **EP 0 302 354 B1**
(45) Veröffentlichungstag und Bekanntmachung des Hinweises auf die Patenterteilung: **03.11.1993**
(21) Anmeldenummer: 88111977.0
(22) Anmeldetag: 25.07.1988
(51) Int. Cl.: C23C 14/22, C23C 14/14, C23C 14/08

(54) **Verfahren zur Herstellung eines schichtartigen Aufbaus aus einem oxidkeramischen Supraleitermaterial**
Method for preparing a laminated structure from an oxide-ceramic supraconducting material
Procédé pour la préparation d'une structure laminée à partir d'un matériau supraconducteur d'oxyde céramique

(30) Priorität: 05.08.1987 DE 3726016
(43) Veröffentlichungstag der Anmeldung: 08.02.1989
(73) Patentinhaber: SIEMENS AKTIENGESELLSCHAFT, 80333 München (DE)
(72) Erfinder: Hoenig, Eckhardt, Dr., D-8520 Erlangen (DE)

(56) Entgegenhaltungen:
- US-A- 4 316 785
- PHYSICAL REVIEW LETTERS, Band 58, 22. Juni 1987, The American Physical Society P.CHAUDHARI et al. "Critical- Current Measurements in EPitaxial Films of YBa2CuO7-x Compound." Seiten 2684-2686
- JAPANESE JOURNAL OF APPLIED PHYSICS, Band 26, Juli 1987, The Japanese Society of Applied Physics and The Physical Society of Japan YOUICHI ENOMOTO et al. " Largely Anisotropic Super- conducting Critical Current in Epitaxially Grown BaYCu307-4 Thin Film." Seiten L 1248-L 1251

## Beschreibung

Die Erfindung bezieht sich auf ein Verfahren zur Herstellung eines schichtartigen Aufbaus aus einem oxidkeramischen supraleitenden Material auf Basis eines metallische Komponenten und Sauerstoff enthaltenden Stoffsystems mit hoher Sprungtemperatur und einer Stromtragfähigkeit von mindestens 10⁴ A/cm² bei der Sprungtemperatur, bei welchem Verfahren die metallischen Komponenten des Systems in einem physikalischen Abscheideprozeß unter Sauerstoffzufuhr auf ein vorbestimmtes Substrat als ein Vorprodukt mit einem bezüglich der auszubildenden supraleitenden Metalloxidphase noch fehlstrukturiertem Gefüge aufgebracht werden, das unter Anwendung einer Wärmebehandlung und unter weiterer Sauerstoffzufuhr in die gewünschte supraleitende Metalloxidphase überführt wird. Ein derartiges Verfahren geht z.B. aus "Physical Review Letters", Vol. 58, No. 25, 22.6.1987, Seiten 2684 bis 2686 hervor.

Filme bzw. dünne Schichten aus supraleitenden Metalloxidverbindungen wie z.B. auf Basis des Stoffsystems Me1-Me2-Cu-O (Me1 = Seltene Erden einschließlich Yttrium; Me2 = Erdalkalimetalle) mit hohen Sprungtemperaturen T_{c} von beispielsweise etwa 40 K oder etwa 90 K werden vielfach mit speziellen Bedampfungs- oder Sputterprozessen hergestellt. Hierbei wird auf einem geeigneten Substrat ein Vorprodukt aus den Komponenten des gewählten Stoffsystems mit einem Gefüge abgeschieden, das hinsichtlich der auszubildenden supraleitenden Metalloxidphase noch fehlstrukturiert ist. Dieses Vorprodukt wird anschließend durch eine im allgemeinen unter Sauerstoffzufuhr durchzuführende Glühbehandlung in das Material mit der gewünschten supraleitenden Phase überführt.

Die so zu erhaltenden supraleitenden Metalloxidphasen, deren Strukturen ähnlich der eines Perowskites sein können, haben im Falle von (La-Me2)₂CuO_{4-y} (mit y ≧ O) einen tetragonalen K₂NiF₄- Aufbau (vgl. "Japanese Journal of Applied Physics", Vol. 26, No. 2, Part 2 - Letters, Februar 1987, Seiten L123 und L124). Demgegenüber wird im Falle von YBa₂Cu₃O₇₋ₓ eine orthorhomische Struktur angenommen (vgl. z.B. "Europhysics Letters", Vol. 3, No. 12, 15.6.1987, Seiten 1301 bis 1307). Da die diese supraleitenden Phasen aufweisenden Materialien einer Oxidkeramik ähnlich sind, werden die entsprechenden Hoch-T_{c}-Supraleiter auch als oxidkeramische Supraleiter bezeichnet.

Darüber hinaus ist es aus der eingangs genannten Veröffentlichung "Phys.Rev.Lett." auch bekannt, Filme auf Basis des Stoffsystems YBa₂Cu₃O₇₋ₓ (x ≈ O) mit orientiertem Kristallwachstum (Epitaxie) auf einem SrTiO₃-Substrat herzustellen. Dabei wird davon ausgegangen, daß dieses Substrat eine [100]-Richtung senkrecht zur Abscheideebene haben muß. Entsprechende Substrate sind üblicherweise einkristallin. Bei dem bekannten Verfahren werden zunächst die drei metallischen Komponenten des Systems aus getrennten Verdampfungsquellen in einer Sauerstoffatmosphäre auf das auf etwa 400°C erhitzte Substrat aufgedampft. Das so erhaltene Vorprodukt mit einer Schichtdicke im 10⁻⁴ cm-Bereich ist jedoch noch fehlstrukturiert. Mittels einer sich bei hoher Temperatur von etwa 900°C daran anschließenden Behandlung unter Sauerstoffzufuhr erhält man dann einen epitaktisch aufgewachsenen Film mit der gewünschten supraleitenden Hoch-T_{c}-Phase. Die so hergestellten Filme zeigen bei 77 K eine hohe Stromtragfähigkeit von über 10⁵ A/cm², da sie weitgehend einkristallin sind.

Die mit den epitaktischen Y-Ba-Cu-O-Filmen bei 77 K erreichten Stromdichten von 10⁵ A/cm² lassen den Einsatz dieser Filme als Verdrahtungsebene in integrierten Schaltkreisen mit z.B. HEM-Transistoren (High Electron Mobility Transistors) als aktiven Elementen möglich erscheinen. Eine Verwendung der in der eingangs genannten Veröffentlichung "Phys.Rev.Lett." beschriebenen Substrate aus SrTiO₃ erfordert jedoch, beim Aufbau einer entsprechenden integrierten Hybrid-Schaltung mit der dann notwendigerweise einzigen Verdrahtungsebene aus dem genannten supraleitenden Material zu beginnen. Die Schaltung aus einem halbleitenden Material müßte dann auf dieser Ebene aufgebaut werden. Entsprechende Techniken werden bisher lediglich für Si-Halbleiterschaltungen beherrscht. Sie sind außerdem mit Qualitätseinbußen verbunden und nur mit großem apparativen und somit finanziellen Aufwand durchzuführen.

Aus der US-A-4,316,785 ist ein Verfahren zur Herstellung eines Josephson-Elementes unter Verwendung von supraleitenden Elektrodenschichten aus einem oxidkeramischen Supraleitermaterial auf Basis des Stoffsystems Ba-Pb-Bi-O zu entnehmen. Auch bei diesem Verfahren wird in den Elektrodenschichten die gewünschte supraleitende Phase erst mittels einer Wärmebehandlung bei Temperaturen von 500 °C oder höher unter gleichzeitiger Sauerstoffzufuhr ausgebildet. Dabei kann die Wärmebehandlung einer der Elektrodenschichten innerhalb einer kurzen Zeitdauer mittels einer Laserstrahlung vorgenommen werden.

Aufgabe der vorliegenden Erfindung ist es, das Verfahren mit den eingangs genannten Merkmalen dahingehend auszugestalten, daß mit ihm hochstromtragfähige Schichten in mehreren Lagen übereinander und auf nicht-einkristallinen Substraten bei verhältnismäßig niedrigen Temperaturen erzeugt werden können.

Diese Aufgabe wird erfindungsgemäß dadurch gelöst, daß auf ein feinkristallines Substrat eine mehrlagige Schicht aus dem supraleitenden Material aufgebracht wird, indem zunächst sukzessive Lagen aus einzelnen Filmen mit jeweiliger Filmdicke unter 10 nm hergestellt werden, wobei zur Ausbildung jedes dieser Filme die metallischen Komponenten des Systems mittels des physikalischen Abscheideprozesses und unter Sauerstoffzufuhr bei einer Temperatur unter 400 °C auf der jeweils vorhandenen Unterlage aufgebracht werden und wobei das so erhaltene Vorprodukt mit Hilfe zeitlich kurzer thermischer Pulse in ein Zwischenprodukt mit einer Säulenstruktur überführt wird, das Säulen in dichter Packung und mit zumindest annähernd senkrecht auf der jeweiligen Unterlage stehenden c-Achsen aufweist, und indem dann in den Zwischenprodukten aller Filme die gewünschte supraleitende Metalloxidphase mittels weiterer Sauerstoffzufuhr und bei einer Temperatur unter 400 °C ausgebildet wird.

Unter einem feinkristallinen Material wird hier jedes ein Säulenwachstum des Vorproduktes ermöglichendes Material verstanden, das aus nur wenige Elementarzellen großen Körnern besteht. Im Falle von Verbindungen wie insbesondere SrTiO₃ ist das Substratmaterial bei röntgenspektroskopischer Untersuchung nur nahezu amorph; d.h. die Unordnung geht nicht bis auf die atomare Ebene hinunter.

Bei den erfindungsgemäßen Maßnahmen wird von der Erkenntnis ausgegangen, daß es zur Ausbildung von Leiterbahnen mit der geforderten Stromtragfähigkeit von mindestens 10⁴ A/cm² bei Temperaturen nahe der kritischen Temperatur T_{c} des Materials eine vollständige Epitaxie auf üblicherweise einkristallinen Substraten wie gemäß der eingangs erwähnten Veröffentlichung "Phys.Rev.Lett." nicht erforderlich ist. Vielmehr genügt ein Säulenwachstum auf entsprechendem feinkristallinen Material, das eine Ausrichtung der c-Achsen der Kristalle der supraleitenden Phase mit perowskit-ähnlicher Struktur zumindest annähernd senkrecht zu der vorgesehenen, in den Filmebenen liegenden Stromführungsrichtung gewährleistet. Demgegenüber können die übrigen Kristallachsen beliebig (statistisch verteilt) ausgerichtet sein. Da nämlich das Hoch-T_{c}-Supraleitermaterial anisotrop ist und im atomaren Feingefüge Schichtstruktur aufweist, so daß die hohe Stromdichte nur durch Führung des Stromes vorzugsweise in den Schichten dieses Feingefüges zustandekommt, reicht es aus, Filme aus dem Supraleitermaterial mit Feingefügeschichten herzustellen, die sich zumindest weitgehend parallel zur Unterlage und somit parallel zur vorherrschenden Stromführungsrichtung erstrecken. D.h., bei einer Ausrichtung der c-Achse senkrecht zur Unterlage kommt es nicht sonderlich auf die Ausrichtung der a- und b-Achsen an. Damit ist das erfindungsgemäße Verfahren gegenüber dem bekannten Epitaxie-Verfahren entsprechend vereinfacht. Außerdem lassen sich vorteilhaft auch mehrlagige Schichten herstellen, die in verschiedenen Ebenen liegen. Folglich ist auch ein Einsatz dieser Schichten in Hybridschaltungen mit halbleitenden Materialien möglich. Dies wird insbesondere durch die verhältnismäßig niedrigen Temperaturverhältnisse bei dem Abscheideprozeß und bei der abschließenden Sauerstoffbeladung des Zwischenproduktes zur Ausbildung der gewünschten Hoch-T_{c}-Phase gewährleistet. Die erforderliche Wärmebehandlung der noch fehlstrukturierten Filme des Vorproduktes zur Ausbildung des Zwischenproduktes wird mit an sich bekannten Einrichtungen zur Erzeugung kurzer thermischer Pulse durchgeführt. Die thermischen Pulse dieser Einrichtungen lassen sich vorteilhaft so dosieren, daß in sehr kurzer Zeit die erforderliche Glühung jedes einzelnen, noch fehlstrukturierten Filmes des Vorproduktes durchzuführen ist. Zwar können dabei auch die darunter- oder danebenliegenden halbleitenden Schichten der Hybridschaltung erhitzt werden; wegen der kurzen Zeit des thermischen Pulses kommen aber praktisch keine die halbleitenden Schichten schädigenden Diffusionsprozesse zustande.

Vorteilhafte Ausgestaltungen des erfindungsgemäßen Verfahrens gehen aus den Unteransprüchen hervor.

Zur weiteren Erläuterung der Erfindung wird auf die schematische Zeichnung Bezug genommen, in deren Figuren 1 bis 3 einzelne Schritte zur Durchführung des erfindungsgemäßen Verfahrens veranschaulicht sind. Figur 4 zeigt eine erfindungsgemäß aufgebaute mehrlagige Schicht, von der in Figur 5 ein Ausschnitt vergrößert dargestellt ist. In den Figuren 6 und 7 sind Verbindungstechniken für solche Schichten angedeutet. Die Figuren 8 und 9 zeigen Anwendungsmöglichkeiten erfindungsgemäß hergestellter Schichten. In den Figuren sind sich entsprechende Teile mit denselben Bezugszeichen versehen.

Mit dem erfindungsgemäßen Verfahren sind mehrlagige Schichten aus dünnen, quasi gestapelten Filmen aus bekannten supraleitenden Hoch-T_{c}-Materialien auf einem feinkristallinen Substrat herzustellen. Als Ausführungsbeispiel sei das Stoffsystem Me1-Me2-Cu-O ausgewählt. Das erfindungsgemäße Verfahren ist jedoch nicht nur auf dieses Stoffsystem beschränkt; d.h., es ist ebensogut auch für andere oxidkeramische, metallische Komponenten und Sauerstoff enthaltende Hoch-T_{c}-Supraleitermaterialien geeignet, die dem genannten Stoffsystem nicht zuzurechnen sind. Die einzelnen Filme, für die gemäß dem Ausführungsbeispiel ein Material der Zusammensetzung Me1-Me2-Cu-O gewählt ist, sollen dabei jeweils eine Filmdicke unter 10 nm, vorzugsweise unter 1 nm haben und eine hohe Stromtragfähigkeit in der Größenordnung von mindestens 10⁴ A/cm² in der Nähe der Sprungtemperatur T_{c} des Materials gewährleisten. Die Filmdicken liegen somit in der Größenordnung der Abstände der Cu-O-Netzebenen, die in den Kristallen der Hoch-T_{c}-Phasen für den Stromtransport verantwortlich gemacht werden (vgl. z.B. "Frankfurter Allgemeine Zeitung", Nr. 166, 22.7.87, Teil: Natur und Wissenschaft, Seiten 21 und 22). Als Ausgangsmaterialien der Filme sind für das gewählte Ausführungsbeispiel Me1 und Me2 aus der Gruppe der Seltenen Erdmetalle wie z.B. Y oder La bzw. aus der Gruppe der Erdalkalimetalle wie z.B. Sr oder Ba zu wählen. Neben Y für Me1 geeignete Materialien sind z.B. in "Japanese Journal of Applied Physics", Vol. 26, No. 5, Part 2 - Letters, Mai 1987, Seiten 815 bis 817 angegeben. Dabei sollen die entsprechenden metallischen Komponenten des Systems Me1-Me2-Cu-O jeweils mindestens ein (chemisches) Element aus den genannten Gruppen enthalten oder jeweils aus diesem mindestens einen Element bestehen. D.h., Me1 und Me2 liegen vorzugsweise in elementarer Form vor. Gegebenenfalls sind jedoch auch Legierungen oder Verbindungen oder sonstige Zusammensetzungen dieser Metalle mit Substitutionsmaterialien als Ausgangsmaterialien geeignet; d.h., mindestens eines der genannten Elemente kann partiell durch ein anderes Element substituiert sein (vgl. z.B. "Journal of the American Chemical Society", Vol. 109, No. 9 1987, Seiten 2848 und 2849). Die für das Substrat zu wählenden Materialien sind insbesondere solche, die feinkristallines Al₂O₃, ZrO₂, MgO oder SrTiO₃ zumindest enthalten. Dabei sind besonders perowskit-oxidische Materialien geeignet, deren Gitterkonstanten Abmessungen aufweisen, die in etwa das Einfache oder Mehrfache (vgl. "Japanese Journal of Applied Physics", Vol. 26, No. 7, Part 2 - Letters, Juli 1987, Seiten L1248 bis L1250) der entsprechenden Abmessungen der a-und/oder b-Achsen der auf ihnen aufwachsenden Säulen des supraleitenden Materials ausmachen.

Aus diesem Grunde ist ein SrTiO₃-Substrat besonders vorteilhaft. Substrate mit einer geeigneten Textur sind allgemein bekannt (vgl.z.B. "Izvestija Akademii Nauk SSSR", Ser.Fiz., Vol. 39, No. 5, Mai 1975, Seiten 1080 bis 1083).

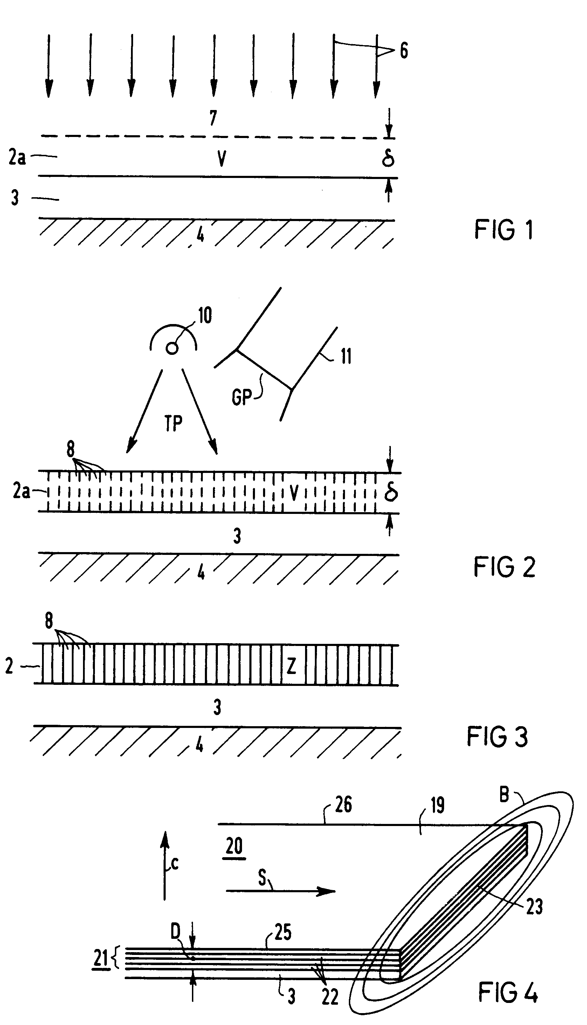

Als ein entsprechendes konkretes Auführungsbeispiel sei gemäß den in den Figuren 1 bis 3 gezeigten Schnitten die Herstellung eines ersten Films einer mehrlagigen Schicht aus einem Material der bekannten Zusammensetzung YBa₂Cu₃O₇₋ₓ zugrundegelegt. Dieser Film soll auf einem Substrat 3 ausgebildet sein. Bei diesem Substrat kann es sich insbesondere um eine auf einem Trägerkörper abgeschiedene, beispielsweise aufgedampfte oder aufgesputterte SrTiO₃- oder (Ba,Sr)TiO₃-Schicht mit feinkristallinem Gefüge handeln, das eine Textur mit vorgegebener ausgeprägter Orientierung aufweist.

Gemäß Figur 1 läßt man zunächst auf einem dünnen, von einem Trägerkörper 4 getragenen Substrat 3 reaktiv einen dünnen Film 2a aus den metallischen Komponenten Y, Ba und Cu des Stoffsystems in einem an sich bekannten PVD (Physical Vapor Deposition)-Prozeß unter Sauerstoffzufuhr bis zu einer maximalen Filmdicke δ unter 10 nm, vorzugsweise unter 1 nm aufwachsen. Dieser Film 2a hat dabei ein bezüglich der auszubildenden supraleitenden Hoch-T_{c}-Metalloxidphase noch fehlstrukturiertes Gefüge. Zur Herstellung dieses Films 2a geht man von Targets aus den drei hochreinen metallischen Komponenten des Systems aus. Wie in Figur 1 durch gepfeilte Linien 6 angedeutet sein soll, wird dann das Material dieser drei metallischen Targets gleichzeitig, beispielsweise mittels einer HF-unterstützten Laser-Verdampfungsanlage, in einer Sauerstoffatmosphäre 7 auf dem Substrat 3 abgeschieden. Das Substrat kann dabei vorteilhaft auf verhältnismäßig niedriger Temperatur gehalten werden. Geeignete Temperaturen liegen zwischen 400°C und Raumtemperatur. Entsprechende Abscheideanlagen sind allgemein bekannt. Die einzelnen Prozeßparameter für den Abscheideprozeß wie insbesondere Druck und Abscheiderate werden hierbei so eingestellt, daß auf dem Substrat 3 allmählich der Film 2a bis zu der erwähnten Filmdicke δ aufwächst. Aufgrund der besonderen Auswahl für das Substrat 3 wird dabei dessen Textur zumindest zum Teil auf die aufwachsenden Kristalle übertragen. Am Ende des Abscheideprozesses liegt dann ein Vorprodukt V des herzustellenden supraleitenden Materials vor, das jedoch hinsichtlich der Hoch-T_{c}-Phase noch fehlstrukturiert ist.

Abweichend von dem geschilderten reaktiven, HF-unterstützten Laser-Verdampfen zum Abscheiden des Vorproduktes sind auch andere PVD-Prozesse wie z.B. ein Aufdampfen mit Hilfe von drei getrennten Elektronenstrahlquellen bei gleichzeitiger Sauerstoffzufuhr möglich (vgl. z.B. Preprint des Beitrags von R.H.Hammond et al. mit dem Titel: "Superconducting Thin Film of Perovskite Superconductors by Electron-Beam Deposition", zu "MRS Symposium on High Temperature Superconductors, Anaheim, California, 23. und 24.4.1987").

Gemäß Figur 2 wird nun das Vorprodukt V in ein Zwischenprodukt überführt, das i.a. noch hinsichtlich der gewünschten Hoch-T_{c}-Phase fehlstrukturiert ist und auch noch nicht die geforderten hohen Stromdichten ermöglicht. Die Ausbildung dieses Zwischenrproduktes geschieht erfindungsgemäß dadurch, daß man einen zeitlich kurzen thermischen Puls TP auf das Vorprodukt bei gleichzeitiger Sauerstoffzufuhr als Gasstrom oder als niederenergetischen Ionenstrom einwirken läßt. Entsprechende Verfahren und Anlagen sind insbesondere aus der Halbleitertechnik allgemein bekannt (vgl. z.B. "Canadian Journal of Physics", Vol. 63, 1985, Seiten 881 bis 885; Firma Eaton Corp., Danvers, Massachusetts: "ROA-400 Rapid Thermal Processor" sowie entsprechende Druckschrift "A Short Course in Rapid Thermal Processing"; Firma Peak Systems Inc., Fremont, California: "ALP 6000 Rapid Thermal Processor"). Dementsprechend wird ein von einer kommerziellen Xe-Lampe 10 erzeugter thermischer Puls TP, ein sogenannter "Flash-anneal-Puls", auf den dünnen Film 2a des Vorproduktes V geschossen. Die Intensität und die Dauer dieses Pulses sind dabei so abgestimmt, daß sich die Kristalle in den einzelnen Atomlagen des Films 2a zu Säulen 8 auf dem texturierten Substrat ausrichten. Die Ausbildung entsprechender Säulenstrukturen unter Verwendung feinkristalliner Unterlagen und durch Wahl geeigneter Wachstumsbedingungen ist z.B. bei der Herstellung von CoCr-Speicherschichten für Datenspeicheranlagen nach dem Prinzip einer vertikalen Magnetisierung bekannt (vgl. z.B. "Japanese Journal of Applied Physics", Vol. 26, No. 6, Part 2 - Letters, Juni 1987, Seiten L923 bis L925). Die erfindungsgemäße Säulenausrichtung parallel zur Normalen auf dem Substrat 3 muß dabei innerhalb weniger Grad erfolgen. Auch dürfen die Säulen 8 nicht vereinzeln, um so hochstromtragfähige Korngrenzen zu schaffen. Für die Ausbildung derartiger Säulenstrukturen reichen im allgemeinen Pulsdauern im Sekundenbereich aus. Wie in Figur 2 ferner angedeutet ist, kann eine für das Säulenwachstum erforderliche Sauerstoffatmosphäre während des thermischen Pulses TP vorteilhaft dadurch erzeugen, daß ein wohldosierter, gerichteter Sauerstoff-Gas-Puls GP oder ein Ionenpuls aus einer Quelle niederenergetischer Sauerstoff-Ionen (mit Energien E ≦ 100 eV) auf den Film 2a geschossen wird. Hierdurch wird vorteilhaft ein Einbau von Sauerstoff in die Kristalle der Säulenstruktur unterstützt. In der Figur ist nur der Austritt des Gas-Pulses GP aus einem entsprechend ausgerichteten Gasrohr 11 veranschaulicht.

Gemäß dem den Figuren 1 und 2 zugrundegelegten Ausführungsbeispiel wird davon ausgegangen, daß zunächst erst die Atomlagen des Films 2a des Vorproduktes V abgeschieden werden, auf die dann anschließend die kurzen thermischen Pulse TP einwirken. Gegebenenfalls ist es jedoch auch möglich, daß bereits während des Abscheideprozesses die thermischen Pulse erzeugt werden, d.h. daß beide Prozesse gleichzeitig durchgeführt werden. Die Anordnung der Blitzlampe 10 muß jedoch so gewählt werden, daß diese bei dem Abscheideprozeß selbst nicht beschichtet wird.

Am Ende des Abscheide- und Wärmebehandlungsprozesses liegt dann gemäß Figur 3 ein erster dünner Film 2 mit den dichtgepackten Säulen 8 vor. Dieser Film stellt ein Zwischenprodukt Z dar, das hinsichtlich der gewünschten supraleitenden Hoch-T_{c}-Phase des herzustellenden Materials im allgemeinen noch fehlstrukturiert ist.

Nachdem auf diese Wiese auf dem Substrat 3 ein erster Film 2 aus dem Zwischenprodukt Z hergestellt wurde, werden nun erfindungsgemäß auf diesem ersten Film noch weitere Lagen aus solchen Filmen in entsprechender Weise aufgebaut. Hierbei übernimmt der jeweils darunterliegende Film die Substratfunktion. Man erhält so einen mehrlagigen Aufbau, der nun noch in das gewünschte supraleitende Material mit hoher Sprungtemperatur und mit der geforderten hohen Stromtragfähigkeit überführt werden muß. Hierzu wird erfindungsgemäß eine Sauerstoff-Feineinstellung in dem Kristallgefüge der Zwischenprodukte Z vorgenommen, indem der gesamte Aufbau einer Sauerstoff-Behandlung in einer Sauerstoffgas- oder vorzugsweise in einer Sauerstoffplasma-Atmosphäre unterzogen wird. Diese Behandlung kann vorteilhaft bei Temperaturen unter 400°C, vorzugsweise nahe Raumtemperatur, ausgeführt werden. Am Ende liegt dann eine auf dem vorbestimmten Substrat abgeschiedene, die geforderten supraleitenden Eigenschaften aufweisende Schicht vor, die sich aus mehreren Lagen aus dünnen supraleitenden Filmen zusammensetzt. Die c-Achsen der Kristallstrukturen dieser Filme liegen dabei zumindest annähernd in Richtung der Normalen auf der Substratoberfläche.

Aus einer Schicht mit einem entsprechenden mehrlagigen Aufbau lassen sich dann z.B. durch bekannte Ionenstrahl-Ätztechniken diskrete Leiterbahnen erzeugen. In Figur 4 ist als Schrägansicht ein Endstück 19 einer eine solche Leiterbahn 20 bildenden mehrlagigen Schicht 21 angedeutet. Gemäß dem dargestellten Ausführungsbeispiel besteht diese auf einem Substrat 3 angeordnete mehrlagige Schicht 21 aus vier übereinanderliegenden supraleitenden Filmen 22, obwohl die Anzahl an Filmen gegebenenfalls wesentlich größer sein kann. Ferner sind in der Figur die Richtung der mit c bezeichneten c-Achse der in den Filmen 22 erfindungsgemäß aufgebauten Kristalle mit der perowskit-ähnlichen Struktur, die Stromführungsrichtung S sowie die sich an der Stirnseite 23 des Endstücks 19 der Leiterbahn 20 ausbildenden Magnetfeldlinien B veranschaulicht. Die Längsseiten dieser Leiterbahn 20 sind mit 25 und 26 bezeichnet.

Wie aus der Ausrichtung der c-Achsen der Kristalle hervorgeht, liegen die stromführenden Ebenen dieser Kristalle parallel zur Filmebene bzw. Substratoberfläche; d.h. die übrigen Kristallachsen können vorteihaft beliebig ausgerichtet sein. Der Grund hierfür ist nämlich, daß an den Kanten (Längsseiten 25, 26) der Filme 22 der Fluß in Form von sogenannten Fluxoiden in die mehrlagige Schicht parallel zu den Filmebenen einzudringen versucht (vgl. z.B. Preprint von H.Noel et al.: "Anisotropy of the Superconducting Magnetic Field H_{c2} of a Single Crystal of TmBa₂Cu₃O₇"), jedoch die Kanten aufgrund der an ihnen ausgebildeten Feldverhältnisse als Flußbarrieren wirken. Voraussetzung hierzu ist, daß die Feldkomponenten parallel zur Filmoberfläche unwirksam bleiben. Dies wird dadurch gewährleistet, daß die Leiterbahn 20 eine Breite B hat, die mindestens eine Größenordnung größer ist als die gesamte Dicke D der mehrlagigen Schicht 21. Dieser Effekt, der quasi als eine Entmagnetisierung der einzelnen Filme aufgrund ihrer geometrischen Ausgestaltung angesehen werden kann, verhindert also ein Einziehen der Fluxoide in der kritischen (Stromführungs-) Richtung. Ein solcher Leiter zeichnet sich dadurch aus, daß an seinen Längsseiten 25, 26 die kritische Feldstärke H_{c1} in Richtung der c-Achsen wesentlich größer ist als in der Filmebene parallel zur Stirnseite 23. Bei der Erfindung wird von der Erkenntnis ausgegangen, daß nicht eine schlechte Leitung senkrecht zu den Filmebenen, sondern das Einziehen solcher Fluxoide (mit normalleitenden Zentren) zwischen die Filme die Stromtragfähigkeit des supraleitenden Materials begrenzt (vgl. "Japanese Journal of Applied Physics", Vol. 26, No. 4, Part 2 -Letters, April 1987, Seiten L377 bis L379). Somit kann bei erfindungsgemäß hergestellten Leiterbahnen ein größerer kritischer Strom in der Ebene senkrecht zur c-Achse transportiert werden als es z.B. in einem Vollmaterial mit ausgeprägt dreidimensionaler Gestalt, sogenanntem Bulk-Material, der Fall ist. Zur Nutzung des genannten Effektes genügt also ein erfindungsgemäßes Säulenwachstum, während eine vollständige Epitaxie wie z.B. gemäß der eingangs genannten Veröffentlichung "Phys.Rev.Lett." nicht erforderlich ist.

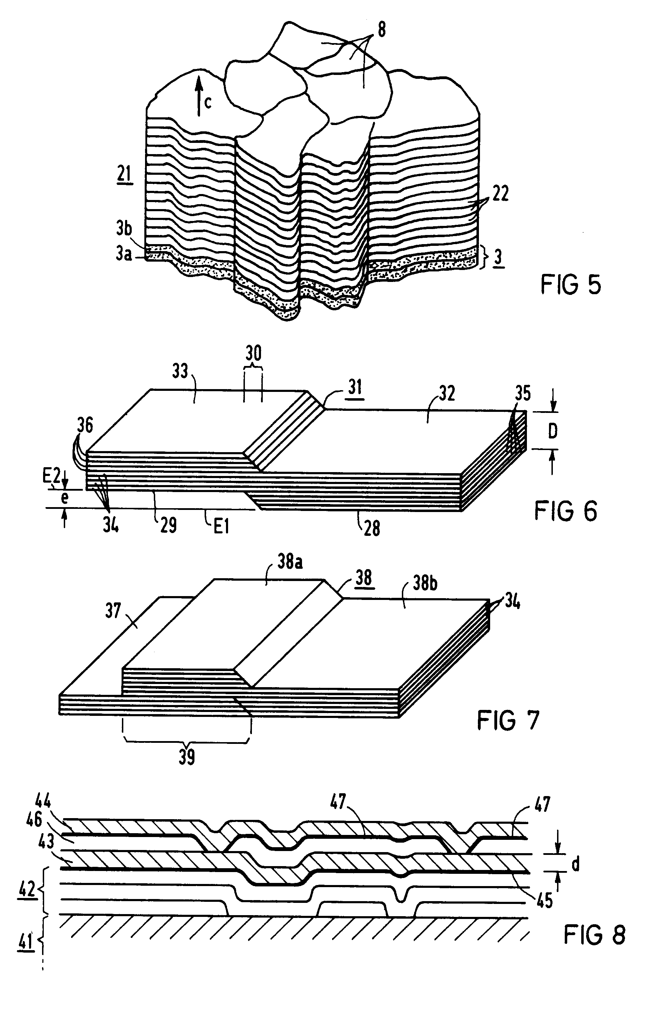

In Figur 5 ist als Schrägansicht ein Ausschnitt aus der in Figur 4 gezeigten mehrlagigen Schicht 21 vergrößert dargestellt. Wie aus dieser Figur ersichtlich ist, kann das Substrat 3, aus dem die mehrlagige Schicht erfindungsgemäß aufgebaut ist, auch aus mehreren dünnen Schichten 3a und 3b des Substratmaterials bestehen. Dabei kann es sich zumindest bei der Schicht 3b um aufgesputtertes feinkristallines SrTiO₃ handeln. Außerdem zeigt die Figur deutlich das in Richtung der c-Achse erfolgte Säulenwachstum der einzelnen Filme 22.

In den Figuren 6 und 7 sind zwei Ausführungsbeispiele in Schrägansicht schematisch dargestellt, aus denen Ausbildungsmöglichkeiten von erfindungsgemäß hergestellten Schichten oder Leiterbahnen mit einem Übergang zwischen zwei Ebenen hervor.

Figur 6 ist eine nicht näher ausgeführte, als Substrat anzusehende Struktur zugrundegelegt, deren Oberfläche in zwei in verschiedenen parallelen Ebenen E1 und E2 liegende Teilflächen 28 und 29 unterteilt ist. Die gegenseitige Entfernung der beiden Ebenen E1 und E2 ist mit e bezeichnet. Die Teilflächen 28 und 29 bilden zwischen sich eine gemeinsame Stufe bzw. einen stufenförmigen Bereich 30 aus. Über diesen Bereich 30 soll eine mehrlagige Schicht 31 hinwegführen. Diese Schicht 31 ist somit durch den stufenförmigen Bereich 30 in zwei Teilstücke 32 und 33 unterteilt, welche in den Ebenen E1 und E2 liegen. Zwischen diesen Teilstücken soll ein Übergang mit der geforderten hohen Stromdichte gewährleistet sein. Hierzu werden erfindungsgemäß auf den beiden Teilflächen 28 und 29 sukzessive mehrere Lagen von Filmen ausgebildet. Die Anzahl der Lagen wird dabei so groß gewählt, daß die jeweilige Gesamtdicke D der Schicht 31 bzw. ihrer Teilstücke 32 und 33 größer als die Entfernung e der Ebene E1 von der Ebene E2 ist. Dann ergeben sich nämlich vorteilhaft mehrere quasi auf der Ebene E2 angeordnete Lagen von ebenen Filmen 34, die sich über den stufenförmigen Bereich 30 hinwegerstrecken und die sowohl dem Teilstück 32 als auch dem Teilstück 33 zuzurechnen sind. Die Filme 34 sind somit quasi - durchgehend ausgebildet. Im Bereich des Teilstücks 32 liegen dann diese Filme 34 auf Filmen 35, welche den Niveauunterschied zwischen den Ebenen E1 und E2 ausfüllen. Hingegen sind auf den Filmen 34 im Bereich der Teilstücke 33 noch Filme 36 abgeschieden. Mit diesen Gestaltungsmaßnahmen läßt sich ein großflächiger Übergang mit hinreichender Breite zwischen den beiden Teilstücken 32 und 33 über den stufenförmigen Bereich 30 hinweg schaffen.

Aufgrund der in Figur 6 dargestellten Ausbildungsmöglichkeit einer Schicht 31 mit einem Übergang von einer Ebene E1 in eine dazu parallele Ebene E2 an einem stufenförmigen Bereich 30 ist auch eine großflächige Kontaktierung zweier erfindungsgemäß herzustellender mehrlagiger Schichten oder Leiterbahnen möglich.

Figur 7 zeigt ein entsprechendes Ausführungsbeispiel. An eine erste mehrlagige Schicht 37 soll eine zweite mehrlagige Schicht 38 so großflächig angefügt sein, daß die geforderte hohe Stromdichte zu gewährleisten ist. Hierzu überlappt die Schicht 38 mit einem Teilstück 38a die Schicht 37 in einem hinreichend großflächigen Kontaktbereich 39. Die Schicht 38 ist deshalb entsprechend der in Figur 6 gezeigten Schicht 31 mit einer Stufe ausgeführt, die das überlappende Teilstück 38a der Schicht 38 von ihrem in der Ebene der Schicht 37 liegenden Teilstück 38b trennt.

Aufgrund der erfindungsgemäßen Maßnahmen ist es somit möglich, dünne Schichten mit mehrlagigem Aufbau aus Hoch-T_{c}-Supraleitermaterial großer Stromdichte in mehreren Ebenen (Etagen) einer Hybridschaltung zu realisieren. Ein entsprechendes Ausführungsbeispiel ist in Figur 8 als Schnitt schematisch veranschaulicht. Die in der Figur nur als Ausschnitt gezeigte Hybridschaltung enthält einen Basiskörper 41 z.B. aus GaAs, aus dem eine beliebige Halbleiterschaltung 42 mit zwischenliegenden Isolierschichten angeordnet ist. Auf dieser Halbleiterschaltung sollen nun erfindungsgemäß zwei als Verdrahtungsebenen dienende, mehrlagige Schichten 43 und 44 aus dem Hoch-T_{c}-Supraleitermaterial mit jeweiliger Schichtdicke d von einigen Zehntel µm ausgebildet werden. Hierzu wird zunächst die freie Oberfläche der Halbleiterschaltung 42 quasi als Träger mit einem dünnen Film aus einem ein Säulenwachstum fördenden Substratmaterial z.B. aus feinkristallinem SrTiO₃ überzogen. Dieser Film ist in der Figur durch eine verstärkte, mit 45 bezeichnete Linie veranschaulicht. Auf diesem Substratfilm 45 wird nun erfindungsgemäß die Schicht 43 der ersten Verdrahtungsebene sukzessive aufgebracht. Da diese Verdrahtungsebene nur an diskreten Stellen mit der weiteren Verdrahtungsebene kontaktiert sein soll, wird anschließend auf der Schicht 43 eine entsprechende, dünne isolierende Zwischenschicht 46 z.B. aus einem Siliziumoxid abgeschieden. Diese Zwischenschicht 46 muß dann noch mit einem ein Säulenwachstum fördernden Film 47 entsprechend dem Film 45 überzogen werden. Gegebenenfalls kann die Zwischenschicht 46 auch aus dem hierfür geeigneten Substratmaterial wie z.B. feinkristallinem SrTiO₃ bestehen. Auf dem so gewonnenen Aufbau wird dann erfindungsgemäß die mehrlagige Schicht 44 der weiteren Verdrahtungsebene aus dem Hoch-T_{c}-Supraleitermaterial sukzessive ausgebildet.

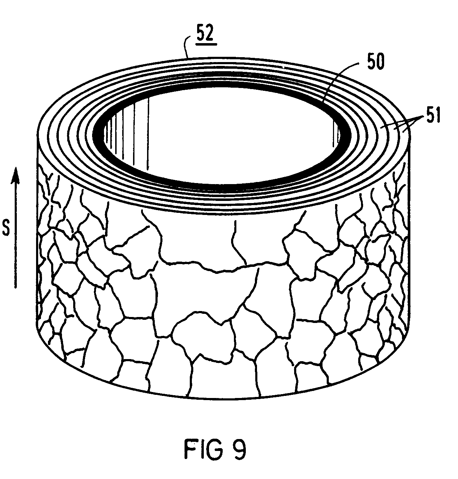

Gemäß den Figuren 1 bis 8 wurde davon ausgegangen, daß das Substrat 3, auf dem ein mehrlagige Schicht erfindungsgemäß zu erstellen ist, stets zumindest annähernd eben oder stufenförmig gestaltet ist. Ebensogut kann das Substrat jedoch auch eine gekrümmte Gestalt haben. So ist beispielsweise gemäß der in Figur 9 gezeigten Schrägansicht ein hohlzylindrisches Substrat 50 von beispielsweise einigen cm Durchmesser vorgesehen. Auf diesem Substrat sind wiederum erfindungsgemäß einzelne Filme 51 einer mehrlagigen Schicht 52 konzentrisch aufgebracht. Die Filme 51 sollen dabei jeweils durch Säulenwachstum mit einer radial nach außen weisenden c-Achse ausgebildet sein. Ein Vorteil dieser Anordnung ist, daß ein Einziehen von Fluxoiden zwischen die einzelnen Filme bei der gewählten Anordnung erschwert ist, da einziehende Fluxoide erst die einzelnen Filme durchdringen müssen. Die durch eine gepfeilte Linie S angedeutete Stromführungsrichtung der Anordnung liegt somit wiederum senkrecht zur c-Achse und parallel zu einer zentralen Achse des hohlzylindrischen Substrates 50.

Der in Figur 9 gezeigte Aufbau kann vorteilhaft innengekühlt werden und ist insbesondere als Leiter zum Transport von elektrischer Energie geeignet. Darüber hinaus ist die gezeigte Rohrkonfiguration für koaxiale, selbstschirmende Leitungen besonders vorteilhaft, bei denen die zueinander koaxial angeordneten rohrförmigen mehrlagigen Schichten beispielsweise einen Hin- und einen Rückleiter bilden.

Wie bereits erwähnt, eignet sich das erfindungsgemäße Verfahren ebenso auch für Stoffsysteme, bei denen eine partielle Substitution zumindest einer der metallischen Komponenten Me1, Me2, Cu vorgenommen wird. Dabei sollte jedoch im allgemeinen der in Atom-% gemessene Anteil des Substitutionselementes wesentlich geringer sein als der der jeweiligen metallischen Komponente. Neben den aus der genannten Veröffentlichung "J.Am.Chem.Soc." bekannten Substitutionsmaterialien für Me1 und Me2 kommt für Me1 als weiteres partielles Substitutionselement A1 in Frage. Cu kann gegebenenfalls durch F partiell substituiert sein. Sind Substitutionsmaterialien vorgesehen, so können diese bei dem erfindungsgemäßen Verfahren entweder gemeinsam mit der zugehörenden Komponente aus einer Quelle oder auch aus einer eigenen Quelle aufgedampft oder aufgesputtert werden.

## Patentansprüche

1. Verfahren Zur Herstellung eines schichtartigen Aufbaus aus einem oxidkeramischen supraleitenden Material auf Basis eines metallische Komponenten und Sauerstoff enthaltenden Stoffsystems mit hoher Sprungtemperatur und einer Stromtragfähigkeit von mindestens 10⁴ A/cm² bei der Sprungtemperatur, bei welchem Verfahren die metallischen Komponenten des Systems in einem physikalischen Abscheideprozeß und unter Sauerstoffzufuhr auf ein vorbestimmtes Substrat als Vorprodukt mit einem bezüglich der auszubildenden supraleitenden Metalloxidphase noch fehlstrukturierten Gefüge aufgebracht werden, das unter Anwendung einer Wärmebehandlung und unter weiterer Sauerstoffzufuhr in die gewünschte supraleitende Metalloxidphase überführt wird, **dadurch gekennzeichnet,** daß auf ein feinkristallines Substrat (3, 45, 47, 50) eine mehrlagige Schicht (21, 37, 38, 43, 44, 52) aus dem supraleitenden Material aufgebracht wird, indem
- zunächst sukzessive Lagen aus einzelnen Filmen (2) mit jeweiliger Filmdicke (δ) unter 10 nm hergestellt werden, wobei zur Ausbildung jedes dieser Filme (2)
a) die metallischen Komponenten des Systems mittels des physikalischen Abscheideprozesses und unter Sauerstoffzufuhr bei einer Temperatur unter 400 °C auf der jeweils vorhandenen Unterlage aufgebracht werden und
b) das so erhaltene Vorprodukt (V) mit Hilfe zeitlich kurzer thermischer Pulse (TP) in ein Zwischenprodukt (Z) mit einer Säulenstruktur überführt werden, das Säulen (8) in dichter Packung und mit zumindest annähernd senkrecht auf der jeweiligen Unterlage stehenden c-Achsen (c) aufweist,
sowie
- dann in den Zwischenprodukten (Z) aller Filme (2) die gewünschte supraleitende Metalloxidphase mittels weiterer Sauerstoffzufuhr und bei einer Temperatur unter 400 °C ausgebildet wird.

2. Verfahren nach Anspruch 1, **dadurch gekennzeichnet,** daß die Sauerstoffbehandlung der Zwischenprodukte (Z) bei einer Temperatur nahe Raumtemperatur vorgenommen wird.

3. Verfahren nach Anspruch 1 oder 2, **dadurch gekennzeichnet,** daß zur Sauerstoffbehandlung der Zwischenprodukte (Z) der Sauerstoff als Gasstrom und/oder als Ionenstrom vorgesehen wird.

4. Verfahren nach einem der Ansprüche 1 bis 3, **dadurch gekennzeichnet,** daß eine mehrlagige Schicht (21, 31, 37, 38, 43, 44, 52) aus supraleitenden Filmen (22, 34, 35, 36, 51) mit einer jeweiligen Dicke (δ) unter 1 nm hergestellt wird.

5. Verfahren nach einem der Ansprüche 1 bis 4, **dadurch gekennzeichnet,** daß als Substrat (3, 50) mindestens eine dünne Schicht (3a, 3b, 45, 47) auf einem Träger (4) vorgesehen wird.

6. Verfahren nach Anspruch 5, **dadurch gekennzeichnet,** daß eine mehrlagige Schicht (43, 44) aus dem supraleitenden Material auf einem Substratfilm (45, 47) aufgebracht wird, für den eine Halbleiterstruktur (42) als Träger dient (Figur 8).

7. Verfahren nach einem der Ansprüche 1 bis 5, **dadurch gekennzeichnet,** daß ein Substrat (50) mit einer rohrförmigen Gestalt vorgesehen wird (Figur 9).

8. Verfahren nach einem der Ansprüche 1 bis 7, **dadurch gekennzeichnet,** daß als Substratmaterial ein Material gewählt wird, dessen Gitterkonstanten Abmessungen aufweisen, die in etwa das Ein- oder Mehrfache der entsprechenden Abmessungen der a- und/oder b-Achsen der Kristalle der auf ihm ausgebildeten Säulen (8) ausmachen.

9. Verfahren nach einem Der Ansprüche 1 bis 8, **dadurch gekennzeichnet,** daß ein Substrat (3, 45, 47, 50) vorgesehen wird, das Al₂O₃ oder ZrO₂ oder MgO oder SrTiO₃ zumindest enthält.

10. Verfahren nach einem der Ansprüche 1 bis 9, **dadurch gekennzeichnet,** daß das Vorprodukt (V) während des thermischen Pulses (TP) einem wohldosierten, gerichteten Sauerstoff-Gas-Puls (GP) und/oder einem niederenergetischen Sauerstoff-Ionen-Puls ausgesetzt wird.

11. Verfahren nach einem der Ansprüche 1 bis 10, **dadurch gekennzeichnet,** daß die thermischen Pulse (TP) während des physikalischen Abscheideprozesses erzeugt werden.

12. Verfahren nach einem der Ansprüche 1 bis 11, **dadurch gekennzeichnet,** daß als physikalischer Abscheideprozeß ein HF-unterstütztes Laser-Verdampfen der getrennten metallischen Komponenten des Systems unter Zufuhr von Sauerstoff als Gas und/oder als Ionenstrom vorgesehen wird.

13. Verfahren nach einem der Ansprüche 1 bis 11, **dadurch gekennzeichnet,** daß als physikalischer Abscheideprozeß ein Verdampfen der getrennten metallischen Komponenten mit Hilfe entsprechender Elektronenstrahlquellen unter Zufuhr von Sauerstoff als Gas und/oder als Ionenstrom vorgesehen wird.

14. Verfahren nach einem der Ansprüche 1 bis 13, **dadurch gekennzeichnet,** daß eine über einen stufenförmigen Bereich (30) eines Substrates hinweg führende mehrlagige Schicht (31) mit zwei zu beiden Seiten des stufenförmigen Bereiches (30) verlaufenden, sich großflächig überlappenden Teilstücken (32, 33) hergestellt wird, wobei in den Teilstücken (32, 33) in gemeinsamen Ebenen liegende, sich über den stufenförmigen Bereich (30) hinweg erstreckende Lagen aus Filmen (35) ausgebildet werden (Figur 6).

15. Verfahren nach einem der Ansprüche 1 bis 14, **dadurch gekennzeichnet,** daß zwei mehrlagige Schichten (37, 38) durch großflächige Überlappung der Schichten in einem Kontaktbereich (39) miteinander verbunden werden (Figur 7).

16. Verfahren nach einem der Ansprüche 1 bis 15, **dadurch gekennzeichnet,** daß aus der mehrlagigen Schicht (21, 31, 37, 38) eine Leiterbahn (20) herausgearbeitet wird, deren Gesamtdicke (D) mindestens eine Größenordnung kleiner als die senkrecht zur Stromführungsrichtung (S) gemessene Breite (B) ist.

17. Verfahren nach Anspruch 16, **dadurch gekennzeichnet,** daß die Leiterbahnen (20) mittels Ionenstrahl-Ätzens strukturiert werden.

18. Verfahren nach einem der Ansprüche 1 bis 17, **dadurch gekennzeichnet,** daß zumindest eine der metallischen Komponenten des Stoffsystems durch ein weiteres Metall teilweise substituiert wird.

19. Verfahren nach einem der Ansprüche 1 bis 17, **dadurch gekennzeichnet,** daß für den schichtartigen Aufbau ein oxidkeramisches supraleitendes Material auf Basis des Stoffsystems Me1-Me2-Cu-O vorgesehen wird, wobei die metallischen Komponenten Me1 und Me2 ein Seltenes Erdmetall (einschließlich Yttrium) bzw. ein Erdalkalimetall zumindest enthalten.

20. Verfahren nach Anspruch 19, **dadurch gekennzeichnet,** daß die erste metallische Komponente Me1 teilweise durch ein anderes Metall aus der Gruppe der für diese Komponente vorgesehenen Metalle oder durch A1 partiell substituiert wird.

21. Verfahren nach Anspruch 19 oder 20, **dadurch gekennzeichnet,** daß die zweite metallische Komponente Me2 teilweise durch ein anderes Metall aus der Gruppe der für diese Komponente vorgesehenen Metalle substitutiert wird.

22. Verfahren nach einem der Ansprüche 19 bis 21, **dadurch gekennzeichnet,** daß das Cu teilweise durch F substituiert wird.

## Claims

1. Process for the production of a layer-like composition of an oxide-ceramic superconductive material based on a material system containing metallic components and oxygen, with a high transition temperature and a current-carrying capacity of at least 10⁴ A/cm² at the transition temperature, in which process the metallic components of the system are applied in a physical deposition process onto a predetermined substrate, and while oxygen is supplied, as a preliminary product with a structure which is still disordered with respect to the superconducting metal oxide phase to be formed, which structure is converted, using a heat treatment and while oxygen continues to be supplied, into the desired superconducting metal oxide phase, characterised in that a multi-layered layer structure (21, 37, 38, 43, 44, 52) of the superconductive material is applied on a fine-crystalline substrate (3, 45, 47, 50), whereby
- first of all successive layers of individual films (2) with a respective film thickness (δ) under 10 nm are produced, whereby to form each of these films (2)
a) the metallic components of the system are applied to the respectively provided underlayer by means of the physical deposition process and while supplying oxygen at a temperature below 400°C and
b) the so-obtained preliminary product (V) is converted with the aid of short thermal pulses (TP) into an intermediate product (Z) with a columnar structure which has columns (8) densely packed, and c-axes (c) standing at least approximately perpendicularly to the respective underlayer,
and
- then the desired superconducting metal oxide phase is formed in the intermediate products (Z) of all films (2) by means of further oxygen supply and at a temperature below 400°C.

2. Process according to claim 1, characterised in that the oxygen treatment of the intermediate products (Z) is carried out at a temperature near room temperature.

3. Process according to claim 1 or 2, characterised in that the oxygen is provided as a gas stream and/or as an ion stream for the oxygen treatment of the intermediate products (Z).

4. Process according to one of claims 1 to 3, characterized in that a multi-layered layer structure (21, 31, 37, 38, 43, 44, 52) of superconducting films (22, 34, 35, 36, 51) is produced with a respective thickness (δ) under 1 nm.

5. Process according to one of claims 1 to 4, characterised in that at least one thin layer (3a, 3b, 45, 47) on a carrier (4) is provided as the substrate (3, 50).

6. Process according to claim 5, characterised in that a multi-layered layer structure (43, 44) of the superconductive material is applied to a substrate film (45, 47) for which a semi-conductor structure (42) serves as the carrier (Figure 8).

7. Process according to one of claims 1 to 5, characterised in that a substrate (50) with tubular shape is provided (Figure 9).

8. Process according to one of claims 1 to 7, characterised in that a material is chosen as the substrate material having lattice constants which have dimensions which amount to about one or several times the corresponding dimensions of the a and/or b axes of the crystals of the columns (8) formed on it.

9. Process according to one of claims 1 to 8, characterised in that a substrate (3, 45, 47, 50) is provided which contains at least Al₂O₃ or ZrO₂ or MgO or SrTiO₃.

10. Process according to one of claims 1 to 9, characterised in that the preliminary product (V) is subjected during the thermal pulse (TP) to a well-dosed directional oxygen-gas-pulse (GP) and/or to a low-energy oxygen-ion pulse.

11. Process according to one of claims 1 to 10, characterised in that the thermal pulses (TP) are generated during the physical deposition process.

12. Process according to one of claims 1 to 11, characterised in that an HF-aided laser evaporation of the separated metallic components of the system is provided as the physical deposition process while supplying oxygen as a gas and/or as an ion stream.

13. Process according to one of claims 1 to 11, characterised in that the physical deposition process comprises evaporation of the separated metallic components with the aid of suitable electron beam sources while oxygen is supplied as a gas and/or as an ion stream.

14. Process according to one of claims 1 to 13, characterized in that a multi-layered layer structure (31) extending over a step-like region (30) of a substrate having two sub-sections (32, 33) extending on both sides of the step-like region (30) and overlapping over a large surface area is produced, where layers of films (35) are formed in the subsections (32, 33) lying in common planes and extending beyond the step-like region (30) (Figure 6).

15. Process according to one of claims 1 to 14, characterised in that two multi-layered layer structures (37, 38) are joined together in a contact zone (39) by an overlap of the layer structures over a large surface (Figure 7).

16. Process according to one of claims 1 to 15, characterised in that, from the multi-layered layer structure (21, 31, 37, 38) a conductor path (20) is formed having a total thickness (D) which is at least one order of magnitude smaller than the width (B) measured perpendicularly to the current conduction direction (S).

17. Process according to claim 16, characterised in that the conductor paths (20) are structured by means of ion-beam etching.

18. Process according to one of claims 1 to 17, characterised in that at least one of the metallic components of the material system is substituted partially by a further metal.

19. Process according to one of claims 1 to 17, characterised in that for the layered composition an oxide-ceramic superconducting material based on the material system Me1-Me2-Cu-O is provided, wherein the metallic components Me1 and Me2 contain at least a rare earth metal (including yttrium) or an alkaline earth metal.

20. Process according to claim 19, characterised in that the first metallic component Me1 is partially substituted by another metal in the group of metals provided for this component or by A1.

21. Process according to claim 19 or 20, characterised in that the second metallic component Me2 is partially substituted by another metal in the group of metals provided for this component.

22. Process according to one of claims 19 to 21, characterised in that the Cu is partially substituted by F.

## Revendications

1. Procédé de préparation d'une structure stratifiée en un matériau supraconducteur formé d'un oxyde céramique à base d'un système de substances comportant des constituants métalliques et de l'oxygène, ayant une température élevée de transition brusque de conduction et une capacité à véhiculer le courant égale au moins à 10⁴ A/cm² à la température de transition brusque, procédé selon lequel les constituants métalliques du système sont déposés, au cours d'un processus de dépôt physique et avec apport d'oxygène, sur un substrat prédéterminé, servant d'ébauche et ayant une texture de structure encore défectueuse par rapport à la phase d'oxyde métallique supraconductrice à former, qui est transformée en la phase d'oxyde métallique supraconductrice souhaitée, en utilisant un traitement thermique et avec envoi supplémentaire d'oxygène, caractérisé par le fait que sur un substrat (3,45,47,50) à cristaux fins, on dépose une couche à plusieurs strates (21,37,38,43,44,52) en le matériau supraconducteur,
- en préparant d'abord des strates successives formées de pellicules (2) ayant des épaisseurs (δ) respectives inférieures à 10 nm et, pour constituer chacune de ces pellicules (2),
a) on dépose les constituants métalliques du système au moyen d'un processus de dépôt physique et avec envoi d'oxygène à une température inférieure à 400°C, sur leur support présent, et
b) on transforme l'ébauche (V) ainsi obtenue à l'aide d'impulsions (TP) thermiques de brève durée, en un produit intermédiaire (Z) de structure à colonnes, comprenant des colonnes (8) entassées de façon dense et ayant des axes c (c), qui sont à peu près perpendiculaires à leur support respectif, ainsi qu'
- en formant la phase d'oxyde métallique supraconductrice souhaitée, dans les produits intermédiaires (Z) de toutes les pellicules (2), au moyen d'un envoi supplémentaire d'oxygène et à une température inférieure à 400°C.

2. Procédé suivant la revendication 1, caractérisé par le fait qu'on effectue le traitement à l'oxygène des produits intermédiaires (Z) à une température proche de la température ambiante.

3. Procédé suivant la revendication 1 ou 2, caractérisé par le fait que pour le traitement à l'oxygène des produits intermédiaires (Z), on prévoit de l'oxygène sous la forme d'un courant gazeux et/ou d'un courant d'ions.

4. Procédé suivant l'une des revendications 1 à 3, caractérisé par le fait qu'on prépare une couche à plusieurs strates (21,31,37,38,43,44,52) constituée de pellicules (22,34,35,36,51) supraconductrices ayant une épaisseur (δ) respective inférieure à 1 nm.

5. Procédé suivant l'une des revendications 1 à 4, caractérisé en ce qu'on prévoit comme substrat (3,50), au moins une couche mince (3a,3b,45,47) sur un support (4).

6. Procédé suivant la revendication 5, caractérisé par le fait qu'on dépose une couche a strates multiples (43,44) en le matériau supraconducteur, sur une pellicule de substrat (45,47), pour laquelle une structure semiconductrice (42) est utilisée comme support (figure 8).

7. Procédé suivant l'une des revendications 1 à 5, caractérisé par le fait qu'on prévoit un substrat (50) de forme tubulaire (figure 9).

8. Procédé suivant l'une des revendications 1 à 7, caractérisé par le fait qu'on choisit comme matériau du substrat, un matériau, dont le paramètre du réseau a des dimensions qui correspondent approximativement aux dimensions correspondantes des axes a et/ou b des cristaux des colonnes (8) formées sur le substrat ou à un multiple de ces dimensions.

9. Procédé suivant l'une des revendications 1 à 8, caractérisé par le fait qu'il est prévu un substrat (3,45,47,50), qui contient au moins Al₂O₃ ou ZrO₂ ou MgO ou SrTiO₃

10. Procédé suivant l'une des revendications 1 à 9, caractérisé par le fait qu'on soumet l'ébauche (V), pendant l'impulsion (TP) thermique, à une impulsion (GP) dirigée d'oxygène gazeux, largement dosée, ou à une impulsion d'ions oxygène de faible valeur énergétique.

11. Procédé suivant l'une des revendications 1 à 10, caractérisé par le fait que les impulsions (TP) thermiques sont produites pendant le processus de dépôt physique.

12. Procédé suivant l'une des revendications 1 à 11, caractérisé par le fait qu'il est prévu, comme processus de dépôt physique, une évaporation par laser, assistée par application de hautes fréquences, des constituants métalliques distincts du système avec apport d'oxygène sous la forme d'un gaz et/ou d'un courant d'ions.

13. Procédé suivant l'une des revendications 1 à 11, caractérisé par le fait qu'il est prévu, comme processus de dépôt physique, un dépôt par évaporation des constituants métalliques distincts à l'aide de sources correspondantes de faisceaux d'électrons avec envoi d'oxygène sous la forme d'un gaz et/ou d'un courant d'ions.

14. Procédé suivant l'une des revendications 1 à 13, caractérisé par le fait qu'on prépare une couche à strates multiples (31), qui s'étend sur une région (30) de forme étagée d'un substrat et qui comporte deux parties (32,33), s'étendant des deux côtés de la région (30) de forme étagée et se recouvrant sur une grande surface, des strates, qui sont situées dans les parties (32,33) dans des plans communs et qui s'étendent sur la zone (30) de forme étagée, étant constituées de pellicules (35) (figure 6).

15. Procédé suivant l'une des revendications 1 à 14, caractérisé par le fait qu'on relie entre elles deux couches à strates multiples (37,38) au moyen d'un recouvrement de grande surface des couches dans une région de contact (39) (figure 7).

16. Procédé suivant l'une des revendications 1 à 15, caractérisé par le fait qu'on aménage, à partir de la couche à strates multiples (21,31,37,38) une voie conductrice (20), dont l'épaisseur totale (D) est inférieure, d'au moins un ordre de grandeur, à la largeur (B) mesurée perpendiculairement à la direction (S) de passage du courant.

17. Procédé suivant la revendication 16, caractérisé par le fait qu'on structure les voies conductrices (20) au moyen d'une gravure par un faisceau d'ions.

18. Procédé suivant l'une des revendications 1 à 17, caractérisé par le fait qu'on remplace partiellement au moins l'un des constituants métalliques du système de matériaux, par un autre métal.

19. Procédé suivant l'une des revendications 1 à 17, caractérisé par le fait que pour la structuration sous la forme de couches, il est prévu un matériau supraconducteur formé d'un oxyde céramique et à base du système de substance Me1-Me2-Cu-O, les constituants métalliques Me1 et Me2 comportant au moins un métal des terres rares (y compris l'yttrium) et un métal alcalino-terreux.

20. Procédé suivant la revendication 19, caractérisé par le fait que le premier constituant métallique Me1 est en partie remplacé par un autre métal du groupe des métaux prévus pour ce constituant ou bien par du A1.

21. Procédé suivant la revendication 19 ou 20, caractérisé par le fait que le second constituant métallique Me2 est remplacé en partie par un autre du groupe des métaux prévus pour ce constituant.

22. Procédé suivant l'une des revendications 19 à 21, caractérisé par le fait qu'on remplace le Cu en partie par du F.
